# EUROPEAN PATENT APPLICATION

(11) **EP 4 760 628 A1**
(43) Date of publication of application: **17.06.2026**
(21) Application number: 24886020.7
(22) Date of filing: 12.09.2024
(51) Int. Cl.: G06Q 50/40, G06Q 50/10, B60L 58/10, G01R 31/396, G06F 16/906

(54) **BATTERY DATA COLLECTION SERVER AND OPERATION METHOD THEREOF**

(30) Priority: 30.10.2023 KR 20230146623
(71) Applicant: LG Energy Solution, Ltd., Seoul 07335 (KR)
(72) Inventor: KIM, Hyo Jung, Daejeon 34122 (KR)
(74) Representative: Goddar, Heinz J.
(86) International application number: PCT/KR2024/013937
(87) International publication number: WO 2025/095342

(57) **Abstract**

A battery data collection server according to one embodiment disclosed herein includes a communication unit configured to receive first data on a battery of a vehicle from at least one of a data collection device or a data storage of the vehicle, a first storage configured to classify and store the first data into 2_1 data and 2_2 data based on a reception path of the first data, a preprocessing unit is configured to convert formats of the 2_1 data and the 2_2 data to generate third data, classify the third data according to the type of the vehicle to generate a plurality of first databases, and extract preset data from the plurality of first databases to generate a second database, and a second storage configured to store the plurality of first databases and the second database.

## Description

### TECHNICAL FIELD

### CROSS-REFERENCE TO RELATED APPLICATION

This application claims priority to and the benefit of Korean Patent Application No. 10-2023-0146623 filed in the Korean Intellectual Property Office on October 30, 2023, the entire contents of which are incorporated herein by reference.

### TECHNICAL FIELD

Embodiments disclosed herein relate to a battery data collection server and a method of operating the same.

### BACKGROUND ART

Recently, research and development on secondary batteries has been actively conducted. Here, the secondary battery is a battery capable of charging and discharging and includes all recent lithium ion batteries in addition to conventional Ni/Cd batteries and Ni/MH batteries. Among secondary batteries, lithium-ion batteries have an advantage of having a much higher energy density than conventional Ni/Cd batteries, Ni/MH batteries, etc. In addition, the lithium-ion batteries may be manufactured in a compact and lightweight form, and thus are used as a power source for a mobile device. In addition, the lithium-ion batteries are attracting attention as a next-generation energy storage medium as a range of use expands to a power source for an electric vehicle.

In addition, the secondary batteries may generally be used as a battery pack including a battery module in which a plurality of battery cells are connected in series and/or parallel. In addition, the secondary batteries may be used as a battery rack including a plurality of battery modules and a rack frame accommodating the battery modules.

Meanwhile, to check a state of a secondary battery included in electric vehicles (EVs), a data collection device inside the vehicle collects and analyzes data of the battery included in the vehicle. However, when the data collection device analyzes the data of the battery, there are limitations that the amount of data collected is small and the collected data is not systematically managed, thereby reducing the efficiency of data analysis.

### DISCLOSURE

### TECHNICAL PROBLEM

Embodiments disclosed herein are directed to providing a battery data collection server and a method of operating the same, which are capable of analyzing battery data of a plurality of vehicles.

Embodiments disclosed herein are also directed to providing a battery data collection server and a method of operating the same, which are capable of increasing the efficiency of battery data analysis by unifying formats of pieces of battery data acquired from different data sources

Embodiments disclosed herein are also directed to providing a battery data collection server and a method of operating the same, which are capable of increasing the efficiency of data analysis on a specific type of vehicle and data analysis about all types of vehicles by separately generating a database for a battery of a specific type of vehicle and a database for all types of vehicles.

The objects of the embodiments disclosed herein are not limited to the above-described objects, and other objects that are not described will be able to be clearly understood by those skilled in the art to which the present disclosure pertains from the following description.

### TECHNICAL SOLUTION

A battery data collection server according to one embodiment disclosed herein includes a communication unit configured to receive first data on a battery of a vehicle from at least one of a data collection device or a data storage of the vehicle, a first storage configured to classify and store the first data into 2_1 data and 2_2 data based on a reception path of the first data, a preprocessing unit is configured to convert formats of the 2_1 data and the 2_2 data to generate third data, classify the third data according to the type of the vehicle to generate a plurality of first databases, and extract preset data from the plurality of first databases to generate a second database, and a second storage configured to store the plurality of first databases and the second database.

According to one embodiment, the battery data collection server may further include an analysis unit configured to analyze battery data based on the second database.

According to one embodiment, the analysis unit may be configured to extract a target database corresponding to a target type of vehicle among the plurality of first databases, and analyze data of a battery included in the target type of vehicle based on the target database.

According to one embodiment, the preprocessing unit may convert formats of the 2_1 data and the 2_2 data using different methods to unify the formats of the 2_1 data and the 2_2 data.

According to one embodiment, the preprocessing unit may correct omissions and errors of the 2_1 data and the 2_2 data to generate the third data.

According to one embodiment, the preprocessing unit may add at least some of pieces of daily data received at a second time point that is a time point after a first time point to real-time data stored at the first time point among the 2_1 data to correct the omission of the 2_1 data.

According to one embodiment, the preprocessing unit may modify at least some of the pieces of real-time data stored at the first time point among the 2_1 data to at least some of the pieces of daily data received at a second time point that is a time point after the first time point to correct the error of the 2_1 data.

According to one embodiment, the second storage may be configured to store storage time points of each of the plurality of first databases and the second database, and extract data that a preset period has elapsed from the storage time points of each of the plurality of first databases and the second database to generate a third database that is a long-term storage database.

According to one embodiment, the second storage may be configured to transmit the third database to a third storage, and delete the third database and the first database and the second database that correspond to the third database.

According to one embodiment, the battery data collection server may further include a scheduler configured to adjust operation cycles of the first storage and the preprocessing unit.

A method of analyzing battery data according to one embodiment disclosed herein includes receiving first data on a battery of a vehicle from at least one of a data collection device or a data storage of the vehicle, classifying and storing the first data into 2_1 data and 2_2 data based on a reception path of the first data, converting formats of the 2_1 data and the 2_2 data to generate third data, classifying the third data according to the type of the vehicle to generate a plurality of first databases, extracting preset data from the plurality of first databases to generate a second database, and storing the plurality of first databases and the second database.

According to one embodiment, the method may further include analyzing battery data based on the second database.

According to one embodiment, the analyzing of the battery data may include extracting a target database corresponding to a target type of vehicle among the plurality of first databases, and analyzing data of a battery included in the target type of vehicle based on the target database.

According to one embodiment, the generating of the third data may include converting formats of the 2_1 data and the 2_2 data using different methods to unify the formats of the 2_1 data and the 2_2 data.

According to one embodiment, the generating of the third data may include correcting omissions and errors of the 2_1 data and the 2_2 data.

According to one embodiment, the generating of the third data may include adding at least some of pieces of daily data received at a second time point that is a time point after a first time point to real-time data stored at the first time point among the 2_1 data to correct the omission of the 2_1 data, and modifying at least some of the pieces of real-time data stored at the first time point among the 2_1 data to at least some of the pieces of daily data received at a second time point that is a time point after the first time point to correct the error of the 2_1 data.

According to one embodiment, the method may further include storing storage time points of each of the plurality of first databases and the second database, and extracting data that a preset period has elapsed from the storage time points of each of the plurality of first databases and the second database to generate a third database that is a long-term storage database.

According to one embodiment, the generating of the third database may include transmitting the third database to a third storage and deleting the third database and the first database and the second database that correspond to the third database.

Detailed matters of other embodiments are included in a detailed description and accompanying drawings.

### ADVANTAGEOUS EFFECTS

The battery data collection server and the method of operating the same according to the embodiments disclosed herein can analyze the pieces of battery data of the plurality of vehicles.

The battery data collection server and the method of operating the same according to the embodiments disclosed herein can increase the efficiency of battery data analysis by unifying the formats of the pieces of battery data acquired from different data sources.

The battery data collection server and the method of operating the same according to the embodiments disclosed herein can increase the efficiency of data analysis on the specific type of vehicle and data analysis about all types of vehicles by separately generating the database for the battery of the specific type of vehicle and the database for all types of vehicles.

The effects of the battery data collection server and the method of operating the same according to the disclosure of the present document are not limited to the above-described effects, and other effects that are not mentioned will be able to be clearly understood by those skilled in the art according to the disclosure of the present document.

### DESCRIPTION OF DRAWINGS

FIG. 1 is a block diagram showing a battery data analysis system according to one embodiment disclosed herein.
FIG. 2 is a view showing an operation of classifying and storing battery data by a server according to one embodiment disclosed herein.
FIG. 3 is a view showing an operation of generating third data by the server according to one embodiment disclosed herein.
FIG. 4 is a view showing an operation of generating a first database and a second database by the server according to one embodiment disclosed herein.
FIG. 5 is a flowchart showing a method of analyzing battery data according to one embodiment disclosed herein.

In the description of the drawings, the same or similar reference numerals may be used for the same or similar components.

### MODE FOR INVENTION

Hereinafter, embodiments of the present invention will be described with reference to the accompanying drawings. However, it should be understood that this is not intended to limit the present disclosure to specific embodiments and includes various modifications, equivalents, and/or alternatives of the embodiments of the present disclosure.

It should be understood that the embodiments of this document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In the present document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. Terms such as "1st," "2nd," "first," "second," "A," "B," "(a)," or "(b)" may simply be used to distinguish the corresponding component from another and do not limit the corresponding components in another aspect (e.g., importance or order).

In the present document, when a certain (e.g., a first) component is described as being "coupled," "connected," or "joined" to another (e.g., a second) component with or without the terms "functionally" or "communicatively" or "coupled" or "connected," this means that the certain component may be connected to another component directly (e.g., in a wired or wireless manner) or indirectly (e.g., through a third component).

A method according to various embodiments disclosed herein may be provided to be included in a computer program product. The computer program product may be traded between sellers and buyers as commodities. The computer program product may be distributed in the form of a device-readable storage medium (e.g., compact disc read only memory (CD-ROM)) or distributed online (e.g., downloading or uploading) via an application store (e.g., Play Store^{™}) or directly between two user devices (e.g., smartphones). The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or a program) of the above-described components may include a single object or a plurality of objects, and some of the plurality of objects may be separately disposed in another component. According to the embodiments disclosed herein, one or more components or operations among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

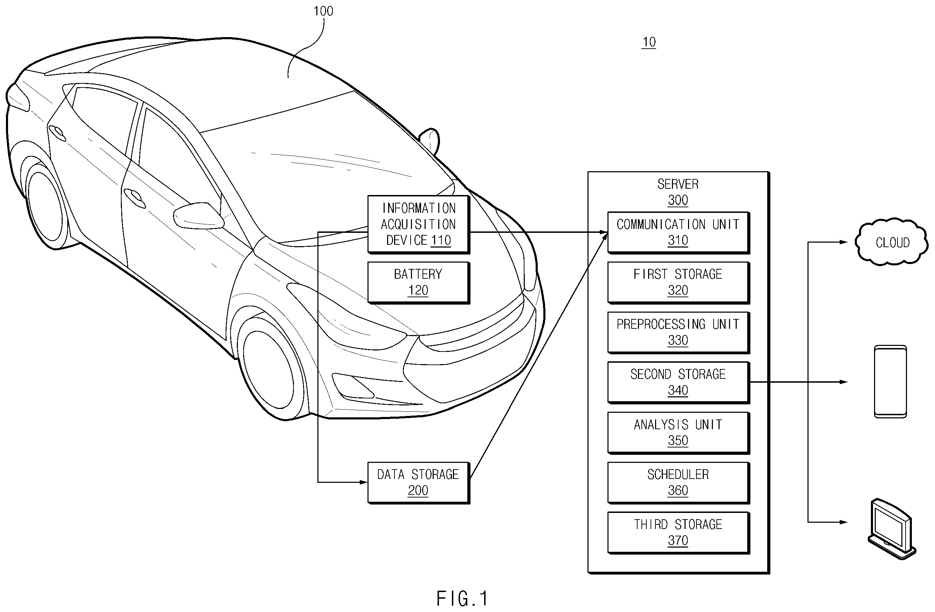

FIG. 1 is a block diagram showing a battery data analysis system according to one embodiment disclosed herein.

Referring to FIG. 1, a battery data collection system 10 may include a target vehicle 100, a data storage 200, and a server 300. The battery data collection system 10 may analyze battery data of the target vehicle 100 in the server 300.

The target vehicle 100 may be an electric vehicle. The target vehicle 100 may be an electric vehicle including a battery 120. That is, the target vehicle 100 may be an electric vehicle (EV), a hybrid EV (HEV), a plug-in HEV (PHEV), or a fuel cell EV (FCEV) that includes the battery 120.

The target vehicle 100 may include an information acquisition device 110. Here, the image acquisition device 110 may include an onboard diagnostic device. That is, the information acquisition device 110 may acquire data of the target vehicle 100 and data on the battery 120 included in the target vehicle 100.

The information acquisition device 110 may generate battery data. According to an embodiment, the information acquisition device 110 may generate battery data based on a state of charge (SOC), a state of health (SOH), an open circuit voltage (OCV), charge capacity, discharge capacity, etc. of the battery 120 acquired from the battery 120.

According to an embodiment, the information acquisition device 110 may generate battery data at a predetermined cycle. The information acquisition device 110 may generate the battery data at a preset cycle while the target device operates or generate battery data by aggregating pieces of information about the battery 120 for one day at a daily cycle.

The information acquisition device 110 may transmit the battery data. According to an embodiment, the information acquisition device 110 may transmit the battery data to at least one of the data storage 200 and the server 300. For example, the information acquisition device 110 may transmit the battery data to the data storage 200, the server 300, or both the data storage 200 and the server 300. According to an embodiment, the information acquisition device 110 may transmit the battery data to at least one of the data storage 200 and the server 300 via Long Term Evolution (LTE) communication.

The data storage 200 may store the battery data. The data storage 200 may classify and store the battery data received from the target vehicle 100.

The data storage 200 may transmit the battery data to the server 300. According to an embodiment, the data storage 200 may store battery data received from a plurality of vehicles and transmit the battery data to the server 300 in response to a request from the server 300.

The server 300 may include a communication unit 310, a first storage 320, a preprocessing unit 330, a second storage 340, an analysis unit 350, a scheduler 360, and a third storage 370. The server 300 may receive battery data from the information acquisition device 110 using each component and classify, store, and analyze the battery data.

The communication unit 310 may receive first data from the plurality of vehicles. According to an embodiment, the communication unit 310 may receive the first data from the plurality of vehicles including the target vehicle 100. For example, the communication unit 310 may communicate with the information acquisition device 110 included in each of the plurality of vehicles to receive the first data from each of the plurality of vehicles. Here, the first data may be battery data on the battery 120 of the target vehicle 100.

The communication unit 310 may receive the first data from the data storage 200. According to an embodiment, the communication unit 310 may receive the first data from one or more data storages 200.

The first storage 320 may classify the first data. According to an embodiment, the first storage 320 may classify the first data into 2_1 data and 2_2 data based on a reception path of the first data. For example, the first storage 320 may separate the first data received from the information acquisition device 110 of the target vehicle 100 and the first data received from the data storage 200 among the pieces of first data. Therefore, the first storage 320 may define the first data received from the information acquisition device 110 of the target vehicle 100 as the 2_1 data and define the data received from the data storage 200 as the 2_2 data. Therefore, the first storage 320 may classify the 2_1 data received from the information acquisition device 110 and the 2_2 data received from the data storage 200.

The first storage 320 may store the first data. The first storage 320 may separately store the 2_1 data and the 2_2 data, which are included in the first data.

The preprocessing unit 330 may convert a format of data. According to an embodiment, the preprocessing unit 330 may convert formats of the 2_1 data and the 2_2 data. For example, the preprocessing unit 330 may convert the format of the 2_1 data set based on controller area network (CAN) communication into a separate format that may be confirmed by a user.

The preprocessing unit 330 may generate third data. The preprocessing unit 330 may generate the third data by converting the formats of the 2_1 data and the 2_2 data to unify the formats of the 2_1 data and the 2_2 data. That is, the third data may be data whose format is unified through format conversion of the 2_1 data and the 2_2 data. According to an embodiment, since the 2_1 data and the 2_2 data have different formats, the preprocessing unit 330 may change the formats of the 2_1 data and the 2_2 data using different methods. That is, the preprocessing unit 330 may generate the third data using a first method for the 2_1 data and generate the third data using a second method differing from the first method for the 2_2 data.

The preprocessing unit 330 may correct the omission of data. The preprocessing unit 330 may correct the omission of the 2_1 data and the 2_2 data. According to an embodiment, the preprocessing unit 330 may compare real-time data stored at a first time point among the 2_1 data with daily data received at a second time point that is a time point after the first time point. Therefore, the preprocessing unit 330 may extract data that does not correspond to the real-time data among the pieces of daily data and adding the above data to the real-time data to correct the omission of the real-time data.

The preprocessing unit 330 may correct an error of data. The preprocessing unit 330 may correct errors of the 2_1 data and the 2_2 data. According to an embodiment, the preprocessing unit 330 may compare real-time data stored at the first time point among the 2_1 data with daily data received at the second time point that is a time point after the first time point. According to an embodiment, the preprocessing unit 330 may compare the real-time data stored at the first time point among the 2_1 data with the daily data received at the second time point, which is a time point after the first time point. Therefore, the preprocessing unit 330 may extract data in which the real-time data does not match the daily data. The preprocessing unit 330 may modify the real-time data to the daily data when the real-time data does not match the daily data to correct an error of the real-time data.

The preprocessing unit 330 may generate a first database ST. The preprocessing unit 330 may generate the first database ST based on the third data. According to an embodiment, the preprocessing unit 330 may classify the third data according to the type of vehicle to generate a plurality of first databases ST. That is, the preprocessing unit 330 may acquire vehicle information that is the basis of the third data from the third data and generate the plurality of first databases ST according to the vehicle information that is the basis of the third data. That is, in the case of third data generated based on data directly or indirectly acquired from a first vehicle type, the preprocessing unit 330 may generate a 1_1 database based on the third data, and in the case of third data generated based on data directly or indirectly acquired from a second vehicle type differing from the first vehicle type, the preprocessing unit 330 may generate a 1_2 database differing from the 1_1 database based on the third data. Therefore, the preprocessing unit 330 may classify the third data according to the type of vehicle.

The preprocessing unit 330 may generate a second database D2. The preprocessing unit 330 may generate the second database D2 based on the plurality of first databases ST. According to an embodiment, the preprocessing unit 330 may extract the preset data from the plurality of first databases ST to generate the second database D2. For example, the preprocessing unit 330 may extract elements necessary for general battery data analysis from the plurality of first databases ST and aggregate the elements to generate the second database D2. Here, the second database D2 may include data on various types of vehicles regardless of the type of vehicle.

The second storage 340 may store the first database ST and the second database D2. The second storage 340 may receive the first database ST and the second database D2 from the preprocessing unit 330 and store the first database ST and the second database D2.

The second storage 340 may store a storage time point. According to an embodiment, the storage may store storage time points of the first database ST and the second database D2.

The second storage 340 may generate a third database. According to an embodiment, the second storage 340 may extract data that a preset period has elapsed from the storage time point of the first database ST or the second database D2 and generate the third database based on the extracted data. Here, the preset period may be determined based on the load, performance, etc. of the second storage 340. In addition, the third database may be a long-term storage database.

The second storage 340 may transmit the third database to a separately provided third storage 370 and delete the first database ST or the second database D2 that corresponds to the third database. Therefore, the second storage 340 may efficiently manage the storage space.

The second storage 340 may store the result of analysis. The second storage 340 may receive and store analysis result information from the analysis unit 350. For example, the storage may store the result of analyzing pieces of battery data included in various types of vehicles and the result of analyzing battery data included in the target type of vehicle.

According to an embodiment, the second storage 340 may transmit the result of analysis to a user. The second storage 340 may transmit the result of analyzing the battery data to the user using the communication unit 310. That is, the second storage 340 may transmit the result of analyzing general battery data to each of the plurality of vehicles or transmit the result of analyzing the battery data of the target vehicle 100 to the target vehicle 100. According to an embodiment, the second storage 340 may upload the result of analyzing the battery data into a cloud so that the user may check the above result in the cloud, and thus transmit the result of analyzing the battery data to the user and directly provide the result of analyzing the battery data to a user terminal or a PC. In addition, the second storage 340 may provide the result of analyzing the battery data through a display provided in the target vehicle 100.

The analysis unit 350 may analyze battery data. The analysis unit 350 may analyze pieces of battery data for the batteries 120 included in various types of vehicles. According to an embodiment, the analysis unit 350 may analyze the pieces of battery data for the batteries 120 included in various types of vehicles based on the second database D2. For example, the analysis unit 350 may analyze real-time battery data or daily data based on the second database D2.

The analysis unit 350 may analyze the pieces of battery data for the batteries 120 included in the target type of vehicle. According to an embodiment, the analysis unit 350 may analyze the battery data for the battery 120 included in the target type of vehicle based on the first database ST. For example, the analysis unit 350 may extract a target database corresponding to the target type of vehicle from the plurality of first databases ST and analyze data of the battery 120 included in the target type of vehicle based on the target database.

The scheduler 360 may control an operation cycle of the first storage 320, the preprocessing unit 330, or the second storage 340. The scheduler 360 may control the first storage 320 to adjust a classification cycle of the first data. The scheduler 360 may control the preprocessing unit 330 to adjust operation cycles of the format conversion of the 2_1 data and the 2_2 data, the classification of the third data, the generation of the second database D2, etc. In addition, the scheduler 360 may control the second storage 340 to adjust periods of the generation of the third database and the deletion of the first database ST and the second database D2.

The third storage 370 may store data. The third storage 370 may receive the third database from the second storage 340 and store the third database. According to an embodiment, the third storage 370 may be a long-term storage device.

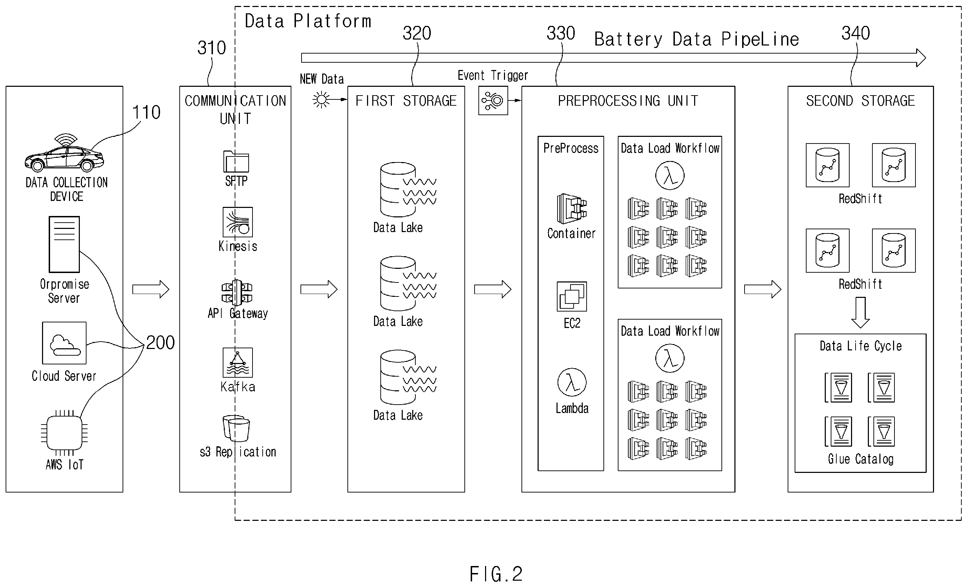

FIG. 2 is a view showing an operation of classifying and storing battery data by a server according to one embodiment disclosed herein.

Referring to FIG. 2, the server 300 may classify and store battery data. According to an embodiment, the communication unit 310 may receive the first data, which is battery data, the first storage 320 may classify the first data to generate and store the second data, the preprocessing unit 330 may convert the format of the second data, generate the first database ST and the second database D2, and the second storage 340 may store the first database ST and the second database D2.

The communication unit 310 may receive the first data from the target vehicle 100 or the data storage 200. Here, the first data may be battery data. The communication unit 310 may transmit the first data to the first storage 320.

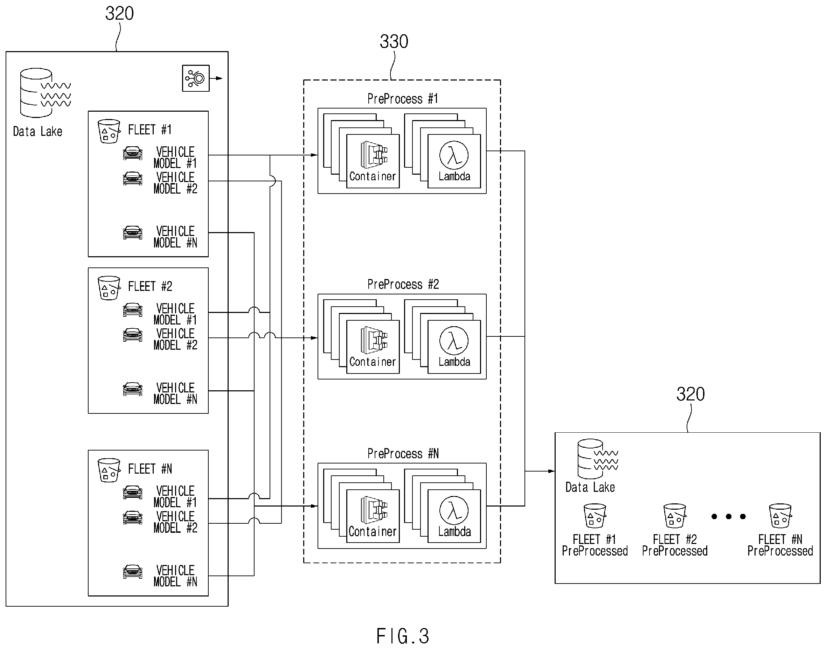

The first storage 320 may classify the first data. The operation of the first storage 320 classifying the first data will be described below in FIG. 3.

The preprocessing unit 330 may convert the formats of the 2_1 data and the 2_2 data to generate the third data and generate the first database ST and the second database D2 based on the third data. In addition, the preprocessing unit 330 may correct the omissions or errors of the 2_1 data and the 2_2 data. The operation of the preprocessing unit 330 converting the formats of the 2_1 data and the 2_2 data and correcting the omissions or errors thereof will be described below in FIG. 3.

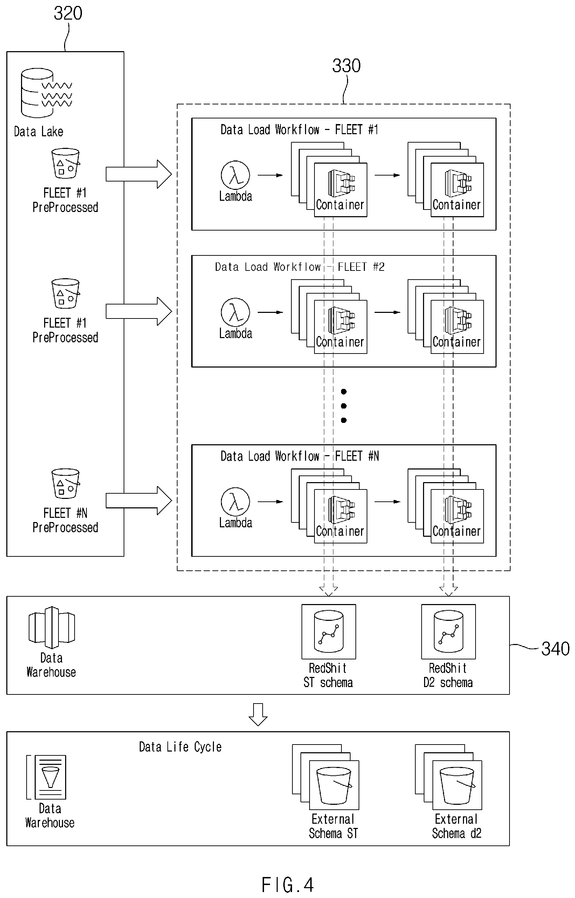

The preprocessing unit 330 may generate the first database ST and the second database D2. The operation of the preprocessing unit 330 generating the first database ST and the second database D2 will be described below in FIG. 4.

The second storage 340 may store the first database ST and the second database D2. The second storage 340 may receive the first database ST and the second database D2 from the preprocessing unit 330 and store the first database ST and the second database D2.

FIG. 3 is a view showing an operation of generating third data by the server according to one embodiment disclosed herein.

Referring to FIG. 3, the first storage 320 may classify the first data. According to an embodiment, the first storage 320 may classify the first data into 2_1 data and 2_2 data based on a reception path of the first data. For example, the first storage 320 may separate the first data received from the information acquisition device 110 of the target vehicle 100 from the first data received from the data storage 200 among the pieces of first data. Therefore, the first storage 320 may define the first data received from the information acquisition device 110 of the target vehicle 100 as the 2_1 data and define the data received from the data storage 200 as the 2_2 data. Therefore, the first storage 320 may classify the 2_1 data received from the information acquisition device 110 and the 2_2 data received from the data storage 200. In such a manner, the first storage 320 may classify the first data into a plurality of pieces of data. For example, when the first storage 320 has n reception paths, the first storage 320 may classify the first data into n pieces of data.

The preprocessing unit 330 may generate the third data. The preprocessing unit 330 may generate the third data by converting the formats of the 2_1 data and the 2_2 data to unify the formats of the 2_1 data and the 2_2 data. That is, the third data may be data whose format is unified through format conversion of the 2_1 data and the 2_2 data. According to an embodiment, since the 2_1 data and the 2_2 data have different formats, the preprocessing unit 330 may change the formats of the 2_1 data and the 2_2 data using different methods. That is, the preprocessing unit 330 may generate the third data using the first method for the 2_1 data and generate the third data using the second method differing from the first method for the 2_2 data. The preprocessing unit 330 may transmit the generated third data to the first storage 320.

The preprocessing unit 330 may correct the omission of data. The preprocessing unit 330 may correct the omission of the 2_1 data and the 2_2 data. According to an embodiment, the preprocessing unit 330 may compare real-time data stored at the first time point among the 2_1 data with daily data received at the second time point that is a time point after the first time point. Therefore, the preprocessing unit 330 may extract data that does not correspond to the real-time data among the pieces of daily data and adding the above data to the real-time data to correct the omission of the real-time data.

The preprocessing unit 330 may correct an error of data. The preprocessing unit 330 may correct errors of the 2_1 data and the 2_2 data. According to an embodiment, the preprocessing unit 330 may compare real-time data stored at the first time point among the 2_1 data with daily data received at the second time point that is a time point after the first time point. According to an embodiment, the preprocessing unit 330 may compare the real-time data stored at the first time point among the 2_1 data with the daily data received at the second time point, which is a time point after the first time point. Therefore, the preprocessing unit 330 may extract data in which the real-time data does not match the daily data. The preprocessing unit 330 may correct the real-time data to the daily data when the real-time data does not match the daily data to correct an error of the real-time data.

FIG. 4 is a view showing an operation of generating a first database and a second database by the server according to one embodiment disclosed herein.

Referring to FIG. 4, the preprocessing unit 330 may generate the first database ST. The preprocessing unit 330 may generate the first database ST based on the third data. According to an embodiment, the preprocessing unit 330 may classify the third data according to the type of vehicle to generate a plurality of first databases ST. That is, the preprocessing unit 330 may acquire vehicle information that is the basis of the third data from the third data and generate the plurality of first databases ST according to the vehicle information that is the basis of the third data. That is, in the case of third data generated based on data directly or indirectly acquired from a first vehicle type, the preprocessing unit 330 may generate a 1_1 database based on the third data, and in the case of third data generated based on data directly or indirectly acquired from a second vehicle type differing from the first vehicle type, the preprocessing unit 330 may generate a 1_2 database differing from the 1_1 database based on the third data. Therefore, the preprocessing unit 330 may classify the third data according to the type of vehicle.

The preprocessing unit 330 may generate a second database D2. The preprocessing unit 330 may generate the second database D2 based on the plurality of first databases ST. According to an embodiment, the preprocessing unit 330 may extract the preset data from the plurality of first databases ST to generate the second database D2. For example, the preprocessing unit 330 may extract elements necessary for general battery data analysis from the plurality of first databases ST and aggregate the elements to generate the second database D2. Here, the second database D2 may include data on various types of vehicles regardless of the type of vehicle.

The preprocessing unit 330 may transmit the first database ST and the second database D2 to the second storage 340. According to an embodiment, the preprocessing unit 330 may separate and transmit the first database ST and the second database D2 to the second storage 340. Therefore, the second storage 340 may store the first database ST and the second database D2.

The second storage 340 may store the first database ST and the second database D2. The second storage 340 may receive the first database ST and the second database D2 from the preprocessing unit 330 and store the first database ST and the second database D2.

The second storage 340 may store a storage time point. According to an embodiment, the storage may store storage time points of the first database ST and the second database D2.

The second storage 340 may generate a third database. According to an embodiment, the second storage 340 may extract data that a preset period has elapsed from the storage time point of the first database ST or the second database D2 and generate the third database based on the extracted data. Here, the preset period may be determined based on the load, performance, etc. of the second storage 340. In addition, the third database may be a long-term storage database.

The second storage 340 may transmit the third database to a separately provided third storage 370 and delete the first database ST or the second database D2 that corresponds to the third database. Therefore, the second storage 340 may efficiently manage the storage space.

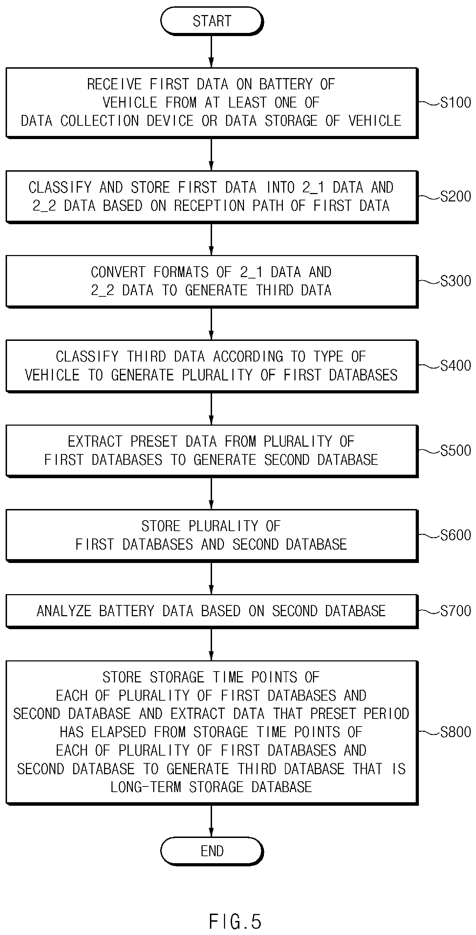

FIG. 5 is a flowchart showing a method of analyzing battery data according to one embodiment disclosed herein.

The embodiment illustrated in FIG. 5 is only one embodiment, the order of operations according to various embodiments of the present invention may be different from that illustrated in FIG. 5, and some operations illustrated in FIG. 5 may be omitted, the order between the operations may be changed, or the operations may be merged.

Referring to FIG. 5, the method of analyzing the battery data may include receiving first data on the battery 120 of a vehicle from at least one of the data collection device or the data storage 200 of the vehicle (S100), classifying and storing the first data into 2_1 data and 2_2 data based on a reception path of the first data (S200), converting the formats of the 2_1 data and the 2_2 data to generate third data (S300), classifying the third data according to the type of the vehicle to generate a plurality of first databases ST (S400), extracting preset data from the plurality of first databases ST to generate the second database D2 (S500), storing the plurality of first databases ST and the second database D2 (S600), analyzing battery data based on the second database D2 (S700), and storing storage time points of each of the plurality of first databases ST and the second database D2 and extracting data that a preset period has elapsed from the storage time points of each of the plurality of first databases ST and the second database D2 to generate the third database that is a long-term storage database (S800).

Hereinafter, operations S100 to S800 will be described in detail with reference to FIGS. 1 to 4.

In operation S100, the server 300 may receive the first data on the battery 120 of the vehicle from at least one of the data collection device or the data storage 200 of the vehicle.

The server 300 may receive the first data from the plurality of vehicles. According to an embodiment, the server 300 may receive the first data from the plurality of vehicles including the target vehicle 100. For example, the server 300 may communicate with the information acquisition device 110 included in each of the plurality of vehicles to receive the first data from each of the plurality of vehicles. Here, the first data may be battery data on the battery 120 of the target vehicle 100.

The server 300 may receive the first data from the data storage 200. According to an embodiment, the server 300 may receive the first data from one or more data storages 200.

In operation S200, the server 300 may classify and store the first data into the 2_1 data and the 2_2 data based on the reception path of the first data.

The server 300 may classify the first data. According to an embodiment, the server 300 may classify the first data into the 2_1 data and the 2_2 data based on the reception path of the first data. For example, the server 300 may separate the first data received from the information acquisition device 110 of the target vehicle 100 and the first data received from the data storage 200 among the pieces of first data. Therefore, the server 300 may define the first data received from the information acquisition device 110 of the target vehicle 100 as the 2_1 data and define the data received from the data storage 200 as the 2_2 data. Therefore, the server 300 may classify the 2_1 data received from the information acquisition device 110 and the 2_2 data received from the data storage 200.

The server 300 may store the first data. The server 300 may separately store the 2_1 data and the 2_2 data, which are included in the first data.

In operation S300, the server 300 may convert formats of the 2_1 data and the 2_2 data to generate the third data.

The server 300 may convert a format of data. According to an embodiment, the server 300 may convert the formats of the 2_1 data and the 2_2 data. For example, the server 300 may convert the format of the 2_1 data set based on CAN communication into a separate format that may be confirmed by a user.

The server 300 may generate the third data. The server 300 may generate the third data by converting the formats of the 2_1 data and the 2_2 data to unify the formats of the 2_1 data and the 2_2 data. That is, the third data may be data whose format is unified through format conversion of the 2_1 data and the 2_2 data. According to an embodiment, since the 2_1 data and the 2_2 data have different formats, the server 300 may change the formats of the 2_1 data and the 2_2 data using different methods. That is, the server 300 may generate the third data using the first method for the 2_1 data and generate the third data using the second method differing from the first method for the 2_2 data.

In operation S400, the server 300 may classify the third data according to the type of vehicle to generate a plurality of first databases ST.

The server 300 may generate the first database ST. The server 300 may generate the first database ST based on the third data. According to an embodiment, the server 300 may classify the third data according to the type of vehicle to generate the plurality of first databases ST. That is, the server 300 may acquire vehicle information that is the basis of the third data from the third data and generate the plurality of first databases ST according to the vehicle information that is the basis of the third data. That is, in the case of third data generated based on data directly or indirectly acquired from a first vehicle type, the server 300 may generate a 1_1 database based on the third data, and in the case of third data generated based on data directly or indirectly acquired from a second vehicle type differing from the first vehicle type, generate a 1_2 database differing from the 1_1 database based on the third data. Therefore, the server 300 may classify the third data according to the type of vehicle.

In operation S500, the server 300 may extract preset data from the plurality of first databases ST to generate the second database D2.

The server 300 may generate the second database D2. The server 300 may generate the second database D2 based on the plurality of first databases ST. According to an embodiment, the server 300 may extract preset data from the plurality of first databases ST to generate the second database D2. For example, the server 300 may extract elements necessary for general battery data analysis from the plurality of first databases ST and aggregate the elements to generate the second database D2. Here, the second database D2 may include data on various types of vehicles regardless of the type of vehicle.

In operation S600, the server 300 may store the plurality of first databases ST and the second database D2.

In operation S700, the server 300 may analyze battery data based on the second database D2.

The server 300 may analyze the battery data. The server 300 may analyze pieces of battery data for the batteries 120 included in various types of vehicles. According to an embodiment, the server 300 may analyze the pieces of battery data for the batteries 120 included in various types of vehicles based on the second database D2. For example, the server 300 may analyze real-time battery data or daily data based on the second database D2.

The server 300 may analyze battery data for the battery 120 included in the target type of vehicle. According to an embodiment, the server 300 may analyze the battery data for the battery 120 included in the target type of vehicle based on the first database ST. For example, the server 300 may extract a target database corresponding to the target type of vehicle from the plurality of first databases ST and analyze data of the battery 120 included in the target type of vehicle based on the target database.

In operation S800, the server 300 may store the storage time points of each of the plurality of first databases ST and the second database D2 and extract data that a preset period has elapsed from the storage time points of each of the plurality of first databases ST and the second database D2 to generate the third database, which is a long-term storage database.

The server 300 may generate the third database. According to an embodiment, the server 300 may extract data that the preset period has elapsed from the storage time point of the first database ST or the second database D2 and generate the third database based on the extracted data. Here, the preset period may be determined based on the load, performance, etc. of the server 300. In addition, the third database may be a long-term storage database.

The above description is merely the exemplary description of the technical spirit disclosed herein, and those skilled in the art to which embodiments disclosed herein pertain will be able to variously modify and change the embodiments without departing from the essential characteristics of the embodiments disclosed herein.

Therefore, the embodiments disclosed herein are not intended to limit the technical spirit disclosed herein, but for describing it, and the scope of the technical spirit disclosed herein is not limited by these embodiments. The scope of the technical spirit disclosed herein should be construed by the appended claims, and all technical spirits within the equivalent range should be construed as being included in the scope of this document.

### [DESCRIPTION OF REFERENCE NUMERALS]

10: battery data collection system
100: target vehicle
110: information acquisition device
200: data storage
300: server
310: communication unit
320: first storage
330: preprocessing unit
340: second storage
350: analysis unit
360: scheduler
370: third storage

## Claims

1. A battery data collection server comprising:
a communication unit configured to receive first data on a battery of a vehicle from at least one of a data collection device or a data storage of the vehicle;
a first storage configured to classify and store the first data into 2_1 data and 2_2 data based on a reception path of the first data;
a preprocessing unit is configured to:
convert formats of the 2_1 data and the 2_2 data to generate third data;
classify the third data according to the type of the vehicle to generate a plurality of first databases; and
extract preset data from the plurality of first databases to generate a second database; and
a second storage configured to store the plurality of first databases and the second database.

2. The battery data collection server of claim 1, further comprising an analysis unit configured to analyze battery data based on the second database.

3. The battery data collection server of claim 2, wherein the analysis unit is configured to:
extract a target database corresponding to a target type of vehicle among the plurality of first databases; and
analyze data of a battery included in the target type of vehicle based on the target database.

4. The battery data collection server of claim 1, wherein the preprocessing unit converts formats of the 2_1 data and the 2_2 data using different methods to unify the formats of the 2_1 data and the 2_2 data.

5. The battery data collection server of claim 1, wherein the preprocessing unit corrects omissions and errors of the 2_1 data and the 2_2 data to generate the third data.

6. The battery data collection server of claim 5, wherein the preprocessing unit adds at least some of daily data received at a second time point that is a time point after a first time point to real-time data stored at the first time point among the 2_1 data to correct the omission of the 2_1 data.

7. The battery data collection server of claim 5, wherein the preprocessing unit modifies at least some of the pieces of real-time data stored at the first time point among the 2_1 data to at least some of the pieces of daily data received at a second time point that is a time point after the first time point to correct the error of the 2_1 data.

8. The battery data collection server of claim 1, wherein the second storage is configured to:
store storage time points of each of the plurality of first databases and the second database; and
extract data that a preset period has elapsed from the storage time points of each of the plurality of first databases and the second database to generate a third database that is a long-term storage database.

9. The battery data collection server of claim 8, wherein the second storage is configured to:
transmit the third database to a third storage; and
delete the third database and the first database and the second database that correspond to the third database.

10. The battery data collection server of claim 1, further comprising a scheduler configured to adjust operation cycles of the first storage and the preprocessing unit.

11. A method of collecting battery data, the method comprising:
receiving first data on a battery of a vehicle from at least one of a data collection device or a data storage of the vehicle;
classifying and storing the first data into 2_1 data and 2_2 data based on a reception path of the first data;
converting formats of the 2_1 data and the 2_2 data to generate third data;
classifying the third data according to the type of the vehicle to generate a plurality of first databases;
extracting preset data from the plurality of first databases to generate a second database; and
storing the plurality of first databases and the second database.

12. The method of claim 11, further comprising analyzing battery data based on the second database.

13. The method of claim 12, wherein the analyzing of the battery data includes:
extracting a target database corresponding to a target type of vehicle among the plurality of first databases; and
analyzing data of a battery included in the target type of vehicle based on the target database.

14. The method of claim 11, wherein the generating of the third data includes converting formats of the 2_1 data and the 2_2 data using different methods to unify the formats of the 2_1 data and the 2_2 data.

15. The method of claim 11, wherein the generating of the third data includes correcting omissions and errors of the 2_1 data and the 2_2 data.

16. The method of claim 15, wherein the generating of the third data includes:
adding at least some of pieces of daily data received at a second time point that is a time point after a first time point to real-time data stored at the first time point among the 2_1 data to correct the omission of the 2_1 data; and
modifying at least some of the pieces of real-time data stored at the first time point among the 2_1 data to at least some of the pieces of daily data received at a second time point that is a time point after the first time point to correct the error of the 2_1 data.

17. The method of claim 11, further comprising:
storing storage time points of each of the plurality of first databases and the second database; and
extracting data that a preset period has elapsed from the storage time points of each of the plurality of first databases and the second database to generate a third database that is a long-term storage database.

18. The method of claim 17, wherein the generating of the third database includes transmitting the third database to a third storage and deleting the third database and the first database and the second database that correspond to the third database.
